# EUROPEAN PATENT SPECIFICATION

(11) **EP 2 327 658 B1**
(45) Date of publication and mention of the grant of the patent: **04.07.2018**
(21) Application number: 09177497.6
(22) Date of filing: 30.11.2009
(51) Int. Cl.: B81C 1/00

(54) **Method for manufacturing microelectronic devices and devices according to such method**
Verfahren zur Herstellung von mikroelektronischen Vorrichtungen und Vorrichtungen gemäß derartiger Verfahren
Procédé de fabrication de dispositifs microélectroniques et dispositifs correspondants

(43) Date of publication of application: 01.06.2011
(73) Proprietor: IMEC VZW, 3001 Leuven (BE)
(72) Inventor: Witvrouw, Ann, 3020, Herent (BE); Haspeslagh, Luc, 3210, Lubbeek-Linden (BE); Claes, Gert, 3010 Kessel-Lo (BE)
(74) Representative: D'Halleweyn, Nele Veerle Trees Gertrudis

(56) References cited:
- EP-A2- 1 460 038
- EP-A2- 1 840 081
- DE-A1- 10 056 716
- US-A1- 2004 245 586
- US-A1- 2005 230 708

## Description

The present invention relates to a method for manufacturing a sealed cavity comprising a MEMS device, and to a microelectronic device comprising such a cavity. The present disclosure relates to the field of microelectronics processing. In particular it relates to zero-level or thin film packaging technology for MEMS devices.

US 2005/0230708 discloses a method for producing a sensor with at least one silicon based micromechanical structure, wherein the sensor chamber is covered with a deposition layer that is transparent to an etching medium, and wherein an oxide in the sensor chamber is removed through the deposition layer, whereupon a sealing layer is applied to the deposition layer.

MEMS devices often need a sealed cavity, for instance when manufacturing a pressure sensor or when packaging a MEMS device with a thin film cap. Electrical connections to the sealed cavity are provided via bond pads adjacent to the sealed cavity. The cavities can be created by surface micromachining: for instance by removing a sacrificial layer through the etching of holes in a capping layer or membrane layer overlying the sacrificial layer. Next the openings in the membrane layer need to be closed to create the sealed cavity. The closure is done by forming a sealing layer overlying the membrane layer, for instance a deposited or reflowed layer. After sealing, the sealing layer needs to be removed at the bond pad locations.

The sealing layer removal step requires lithography and etching processes, which are very difficult if the surface on which they are applied comprises large topography variations.

As membranes for thin film packaging are often 10 to 20 micrometer thick, such topography variations can certainly cause problems.

In order to limit such problems, it is recommendable to have a process flow maintaining an almost flat surface, i.e. with a typical maximum of roughly 1 micrometer of topography variation, up until the last lithography step.

In the paper 'Stable Thin Film Encapsulation of Acceleration Sensors Using Polycrystalline Silicon as Sacrificial and Encapsulation Layer', Sensors and Actuators, Vol 114/2-3 pp 355-361 (2004), A. Hoechst et al., it was proposed to form narrow trenches, i.e. having roughly the same width as the etch holes in the membrane layer, when forming the etch holes in the membrane. The narrow trenches split up the membrane layer into separate membrane blocks, one for each cavity present on the common substrate, and separate also the bond pads from the membrane blocks. The narrow trenches are sealed during the sealing process of the etch holes, while the resulting membrane surface is sufficiently planar for subsequent lithography. This solution however limits the possible membrane shape and may lead to capacitive coupling between the bond pads and the membrane, as the allowed spacing is small. Moreover, the membrane blocks may be short circuited when the sealing layer is conductive, typically resulting in a failing device.

There is a need for alternative encapsulation methods which maintain a substantially flat surface up until the last lithography step, and which solves at least some of the above mentioned problems.

The method of the invention has the features of claim 1. The microelectronic device of the invention has the features of claim 7.

According to a first aspect of the present disclosure, a method is disclosed for manufacturing a sealed cavity comprised in a microelectronic device, comprising forming on a substrate a sacrificial layer at least at locations where the cavity is to be provided, depositing a membrane layer on top of the sacrificial layer overlying the substrate, patterning the membrane layer in at least two separate membrane layer blocks whereby at least one membrane block corresponds to the location of a cavity, removing the sacrificial layer through the membrane layer blocks thereby forming the cavity, and thereafter sealing the cavity by sealing the membrane layer blocks wherein the patterning of the membrane layer into at least two separate membrane layer blocks is performed only after removal of the sacrificial layer.

For the purpose of the present disclosure a sacrificial layer is a layer which is intended to be, at least in part, removed before the finalisation of the respective semiconductor device. Typically sacrificial layers are layer which can be used to temporarily support structural elements or layers of a semiconductor device.

The membrane is patterned such that the resulting membrane blocks are disconnected, i.e. they are not in physical and/or electrical contact with each other.

By postponing the definition of the membrane layer, by patterning the membrane layer into at least two separate membrane layer blocks, the mechanical strength of the intermediate or final device can be increased.

It should be noted that in typical process sequences of the prior art, the membrane layer is defined simultaneously with the creation of the etch holes in the membrane layer at the location of the cavity, such that portions of the sacrificial layer underlying the membrane layer at locations different from locations where cavities are to be formed, may also be removed. In other words, there is a risk that the sacrificial layer can be removed through the trenches separating the membrane layer blocks. This may weaken the physical strength of the device or parts thereof.

According to preferred embodiments of the first aspect of the present disclosure, patterning the membrane layer in order to define at least two separate membrane layer blocks is performed after sealing of the membrane layer.

By further postponing the definition of the membrane layer until after sealing of the membrane layer, the intermediate topography of the processing surface is strongly reduced, when compared to typical process sequences wherein the definition of the membrane layer is performed contemporarily with the creation of the etch holes in the membrane. This means that lithography and etching processes for sealing layer removal can be applied more accurately.

According to preferred embodiments of the first aspect of the present disclosure, the method is performed on a substrate which comprises at least one buried metal layer. The substrate can for instance be a CMOS wafer.

According to preferred embodiments of the first aspect, a plurality of sealed cavities is produced contemporarily. The sealed cavities can be formed adjacent to each other, during a process of wafer level processing whereby process steps are applied over substantially the entire surface of the substrate, such as a wafer. The cavities can be substantially equal in shape, can be similar or may differ substantially in shape. Parallel processing of different devices per wafer is thus possible. Such a parallel processing may advantageously comprise the processing of mainly identical devices.

According to preferred embodiments of the first aspect, the method comprises forming a bond pad on the membrane layer, such that an electrical connection is created between the bond pad and the membrane layer at a location adjacent to the cavity.

According to preferred embodiments of the first aspect, patterning the membrane layer comprises forming a cap membrane layer block positioned substantially above the cavity.

According to preferred embodiments of the first aspect, patterning the membrane layer comprises forming a bond pad membrane layer block positioned adjacent to the cavity. In embodiments wherein the bond pad is present, the bond pad membrane layer block can comprises the bond pad. The bond pad membrane layer block is typically positioned adjacent to the cavities at a distance of the cap membrane layer block, when looking at a top view of the patterned membrane layer.

According to advantageous embodiments of the first aspect of the present disclosure, the patterning of the membrane layer in at least two separate membrane layer blocks is performed after formation of the bond pad. This allows a more successful formation of the bond pad, as it can be formed on a substantially flat surface. The patterning of the membrane layer in order to define at least two separate membrane layer blocks preferably separates the bond pad from sidewalls of the cavity.

According to preferred embodiments of the first aspect of the present disclosure, the method further comprises manufacturing at least one MEMS device within the cavity and providing an electrical connection for the MEMS device, the electrical connection comprising the buried metal layer. The electrical connection is preferably a connection between the bond pad and the MEMS device. Hereby, the MEMS device is thus connected electrically with the buried metal layer and preferably further with the bond pad.

According to preferred embodiments of the first aspect of the present disclosure, wherein at least one MEMS device is manufactured, the method comprises the formation of a structural MEMS layer, at least a first portion of which is comprised in the MEMS device and at least a second portion of which is comprised in the electrical connection between the MEMS device and the bond pad.

For the purpose of the present disclosure a structural layer is a layer which is intended to be, at least partially, part of a functional microelectronic device.

According to typical embodiments of the present disclosure, removing the sacrificial layer through the membrane layer further comprises patterning the membrane layer at a location sunstantially above the cavity, in order to provide at least one etch hole for removing at least part of the sacrificial layer below the membrane layer, independently of the patterning process of the membrane layer wherein at least two separate membrane layer blocks are defined. The process can optionally be performed after a planarization process of the deposited membrane layer.

The patterning of the membrane layer, in any of the other embodiments, into at least two separate membrane layer blocks, preferably comprises isolating the bond pad and the bond pad membrane layer block from the cap membrane layer block and the sidewall of the corresponding cavity.

According to a second aspect of the present disclosure, a microelectronic device is disclosed comprising a cavity, a membrane layer above the cavity and closing off the cavity, the membrane layer being adapted for allowing the removal of a sacrificial material within the cavity through the membrane layer, wherein the membrane layer is a single piece layer.

In another view the membrane layer is not being patterned in order to define at least two separate membrane layer blocks (as for instance a cap membrane layer block and a bond pad membrane layer block). In still another view the membrane layer is an interconnected layer. Viewed otherwise, the membrane layer is such that between any pair of randomly selected points on the surface of the layer a single continuous line can be drawn connecting them.

This aspect of the present disclosure relates to a characteristic intermediate device produced while performing methods according to the first aspect of the present disclosure.

According to preferred embodiments of the second aspect of the present disclosure, the sacrificial material is applied in layers and is thus layered.

According to preferred embodiments of the second aspect of the present disclosure, the microelectronic device further comprises at least one etch hole in the membrane layer above the cavity, said etch hole communicating with the cavity.

According to preferred embodiments of the second aspect of the present disclosure, the microelectronic device comprises at least one sealing layer covering and sealing the membrane layer above said cavity. The at least one sealing layer can be provided on a substantially flat surface, and can thus comprise a substantially flat lower surface.

According to preferred embodiments of the second aspect of the present disclosure, the microelectronic device comprises packaging anchors defining the sidewalls of the cavity, and comprises at least a support structure of sacrificial material at locations outside the cavity, the support structure being formed by a portion of sacrificial material used for temporarily filling the cavity with sacrificial material. The support structure can provide support for the sidewalls of the cavity or for structures outside said cavity.

According to preferred embodiments of the second aspect of the present disclosure, the support structure comprises a substantially flat upper surface at a level which corresponds with the level of the lower surface of the membrane layer. According to preferred embodiments the portion is surrounding and joining the packaging anchors or structures outside said cavity.

The structures outside the cavity can be for instance electrical connection structures. The electrical connection structures can provide an electrical connection from a location near the front surface of the semiconductor device towards a buried conductor layer, and further towards the MEMS device present in the cavity by means of the buried conductor layer. The electrical connection can comprise a pillar-type structure with one end located near the front surface of said device and the other end abutting on said buried metal layer. The remaining portions of the sacrificial layers can thus be located such that they provide mechanical support for said pillar structures located outside the cavity.

According to preferred embodiments the membrane layer is extending over the whole surface of the substrate.

According to a third aspect of the present disclosure, a microelectronic device is disclosed comprising a sealed cavity delimited by a substrate, sidewalls of the cavity, and a cap membrane layer block positioned above the cavity, wherein at least a support structure is present at locations outside the cavity, the support structure being formed by a portion of sacrificial material used for temporarily filling the cavity. This aspect of the present disclosure relates to devices produced by performing methods according to the first aspect of the present disclosure.

The support structure can provide support for the sidewalls of the cavity of for structures outside said cavity.

According to preferred embodiments of the third aspect of the present disclosure, the sacrificial material is applied in layers and is thus layered.

The structures outside the cavity can be the same as those described for aspects of the second aspect of the present disclosure.

According to preferred embodiments of the third aspect of the present disclosure, the substrate comprises at least one buried metal layer, and the cavity comprises a MEMS device, the microelectronic device further comprising a bond pad membrane layer block positioned adjacent to the cavity, the cap membrane layer block and the bond pad membrane layer block being electrically isolated from each other. The cap membrane layer block and the bond pad membrane layer block are preferably originating from a same membrane layer.

According to preferred embodiments of the third aspect of the present disclosure, the membrane layer blocks positioned adjacent to the cavities are supporting a bond pad, and the device comprises an electrical connection between the bond pad and the MEMS device, the electrical connection comprising the bond pad membrane block and the buried metal layer.

According to preferred embodiments of the third aspect of the present disclosure, the support structure mechanically supports the electrical connection. For providing support to the electrical connection, the portion of sacrificial material is preferably located adjacent or joining said electrical connection.

According to preferred embodiments of the third aspect of the present disclosure, in any of the other embodiments of the third aspect, the portion of sacrificial material is located adjacent to the electrical connection of the bond pad, at the level of a structural layer forming or comprised in the MEMS device, the electrical connection comprising at least part of the structural layer. Also, the portion of sacrificial material can be located below that level, i.e. between that level and the substrate.

According to preferred embodiments of the third aspect of the present disclosure, the portion of sacrificial material comprises a substantially flat upper surface at a level which corresponds with the level of the lower surface of the cap membrane layer block. According to preferred embodiments the portion is surrounding the sidewalls of said cavity.

According to preferred embodiments of the third aspect of the present disclosure, the electrical connection between the MEMS device and the bond pad is electrically isolated from the sidewalls of the cavity comprising the MEMS device.

According to preferred embodiments of the third aspect of the present disclosure, the electrical connection between the MEMS device and the bond pad or between the MEMS device and the bond pad membrane layer block does not form part of a sidewall of the cavity.

According to preferred embodiments of the third aspect of the present disclosure, in any of the other embodiments, the electrical connection between the MEMS device in the cavity and the bond pad is located outside the cavity. Preferably the electrical connection does not comprise a metal line located within the cavity. Preferably the MEMS device is electrically contacted via a buried metal layer underneath the cavity.

Features and embodiments for the first, second and third, aspect of the present disclosure, corresponding to features and embodiments of one or more of the other aspects of the present disclosure, are similarly considered to be within the scope of the present disclosure, as will be recognised by the skilled person.

### Brief description of the drawings

The accompanying drawings are used to illustrate embodiments of the present disclosure.

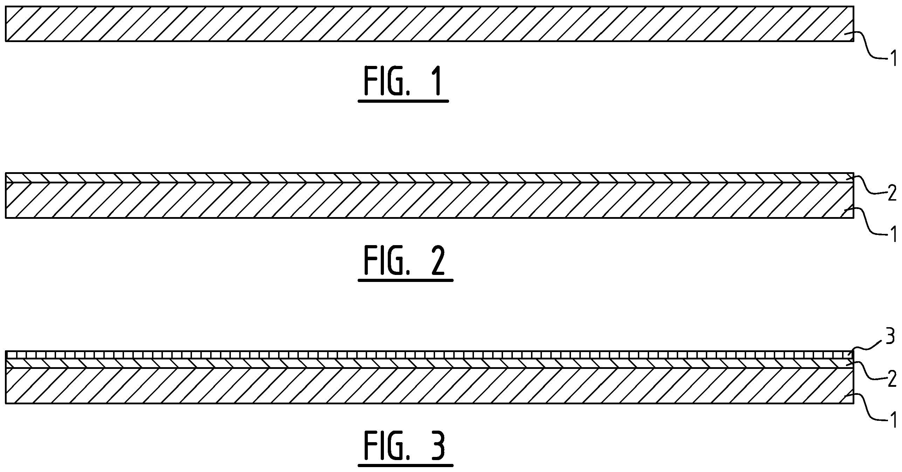

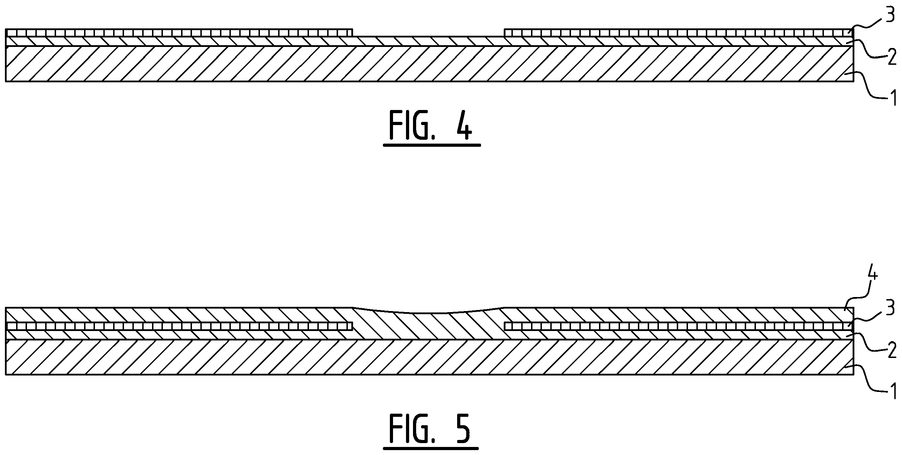

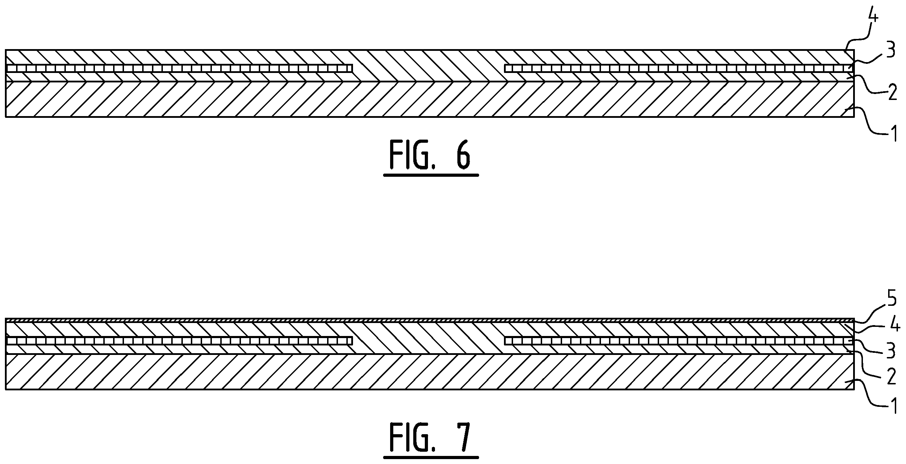

Fig. 1 to Fig. 30 illustrate a process flow according to a preferred embodiment of the present disclosure.

Reference signs are chosen such that they are the same for similar or equal elements or features in different figures or drawings.

### Description of illustrative embodiments

The above and other advantageous features and objects of the disclosure will become more apparent and the disclosure will be better understood from the following detailed description when read in conjunction with the respective drawings.

The description of aspects of the present disclosure is performed by means of particular embodiments and with reference to certain drawings but the disclosure is not limited thereto. Depicted figures are only schematic and should not be considered as limiting. E.g. certain elements or features may be shown out of proportion or out of scale with respect to other elements.

In the description of certain embodiments according to the present disclosure, various features are sometimes grouped together in a single embodiment, figure, or description thereof for the purpose of aiding in the understanding of one or more of the various inventive aspects. This is not to be interpreted as if all features of the group are necessarily present to solve a particular problem. Inventive aspects may lie in less than all features of such a group of features present in the description of a particular embodiment.

In Fig. 1 a substrate 1, for instance a silicon wafer, is provided. On top of a main surface of the silicon wafer, a silicon oxide (SIO₂) layer 2 with a thickness of e.g. 300 nm, is deposited (Fig. 2). A conductive layer comprising different sub layers 3 is deposited on top of the layer 2. The conductive layer constitutes a buried metal layer. The sub layers can comprise for instance a Ti/AlCu/Ti/TiN stack with a thickness of for instance 20 nm/590 nm/20 nm/45 nm(Fig. 3). Then the metal layer 3 is patterned as depicted in Fig. 4 by making use of a mask. The metal layer 3 can be the top metal layer of an interconnect scheme of semiconductor substrate comprising active components such as circuits. The MEMS device is then processed on top of electronic circuitry formed on the substrate. A silicon oxide (SIO₂) layer 4 of about 1500 nm thickness is deposited (see Fig. 5) after which a chemical mechanical polishing (CMP) step is performed in order to flatten the front surface (Fig. 6). The layer 4 is typically sufficiently thick to allow planarizing of the substrate surface. Then a 300 to 400 nm SiC protection layer 5 is deposited (Fig. 7). Openings in layers 5 and 4 are formed using lithographic patterning to form contact holes to the buried metal layer 3. Via the contact holes an electrical connection can be formed between on the one hand a MEMS device in the cavity and on the other hand the bond pad adjacent to the cavity. The contact etch has been performed with a etch stop on the TiN 3, (Fig. 8).

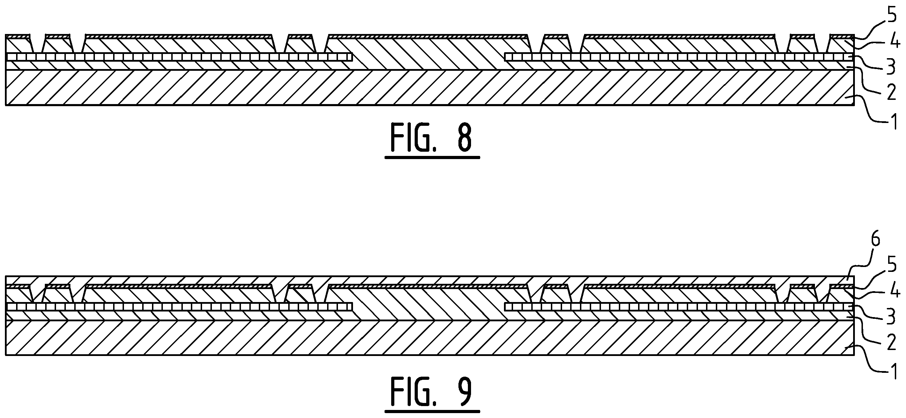

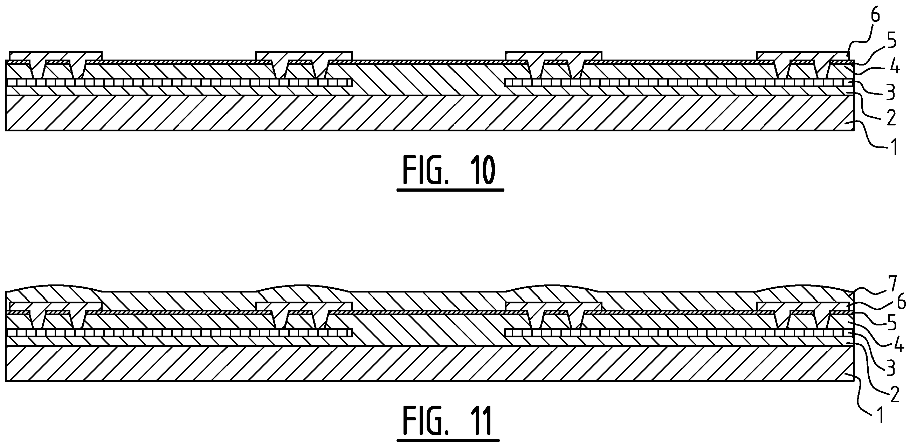

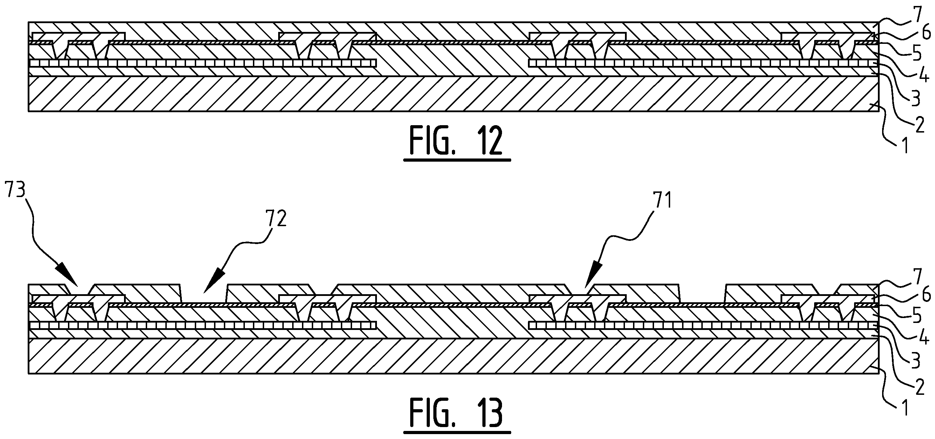

Then a silicon germanium electrode layer 6 is deposited by means of chemical vapour deposition (CVD), for instance having a thickness of 400 nm (Fig. 9), and being connected to the top CMOS electrode layer 3. The silicon germanium layer 6 is patterned into silicon germanium electrodes.(Fig. 10), whereupon another sacrificial silicon oxide (SiO₂) layer 7 (thickness typically of about 1 to 3 pm) is deposited (Fig. 11). The sacrificial layer is planarized by applying a chemical mechanical polishing step (Fig. 12), reducing the surface topography for the further lithography steps. A further contact etch is performed by opening the sacrificial oxide 7 to define packaging anchors 72 and MEMS feed-throughs 73 (Fig. 13).

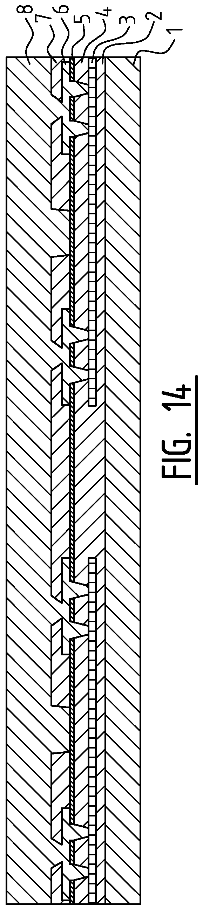

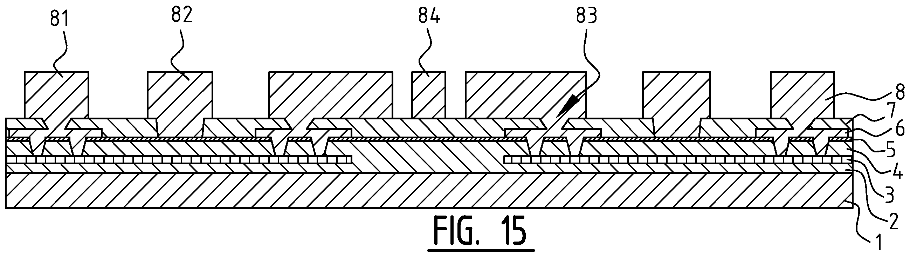

Now, the structural silicon germanium layer 8 is deposited (Fig. 14), typically with a thickness of 1 to 8 pm, optionally together with a 100 nm SiC layer 9 (not depicted). The structural layer is used to form the MEMS device. Then the structural silicon germanium layer (and optionally the SiC layer) is patterned to form the MEMS device 84, part of the packaging anchors 82 and part of the electrical connection 83 between the buried metal layer 3 and the bond pad (Fig. 15).

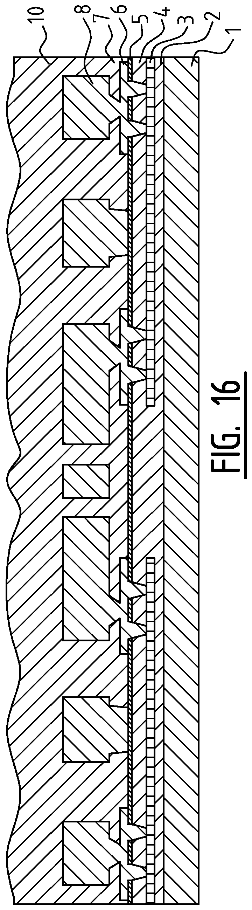

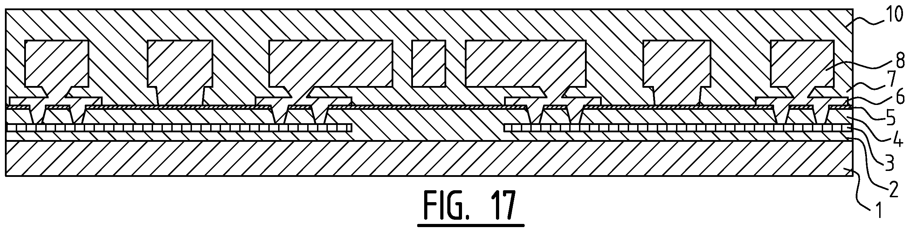

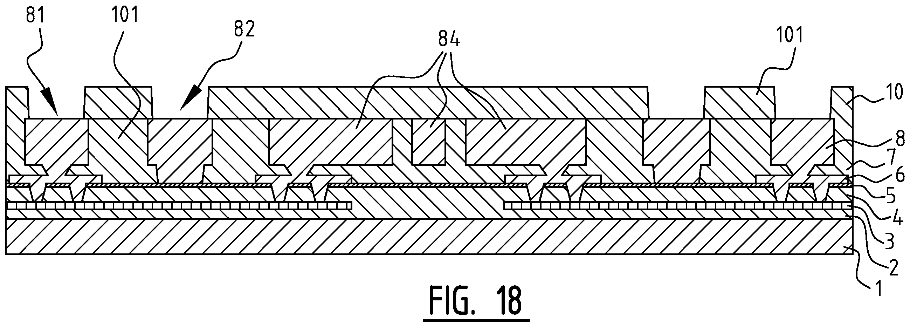

Then, the structure is covered by depositing a silicon oxide layer 10 filling the gaps within the structural layer (Fig. 16). A chemical mechanical polishing (CMP) process is applied from the front main surface on the oxide filling layer 10 (Fig. 17) in order to reduce the topography of the front surface, and hereby defining the gap between the structural silicon germanium layer 8 and the silicon germanium membrane layer 12 which is to be deposited later. Optionally, the CMP process can be applied up until the level of the SiC layer 9 (CMP stopping layer), if present. In the latter case, another silicon oxide (SIO₂) layer 11 is deposited, hereby defining the gap between the structural silicon germanium layer and the silicon germanium membrane layer which will be deposited later. Now, the membrane contact etch is performed in the oxide layer 10 (Fig. 18), to form the anchors 82 of the capping layer and part of the electric connection 81 to the bond pad. Note that remaining portions 101 of the sacrificial layer are present, which can support the electrical connection 81 and the package sidewall or cavity sidewall. The remaining portion has a substantially flat upper surface because of the previous processing.

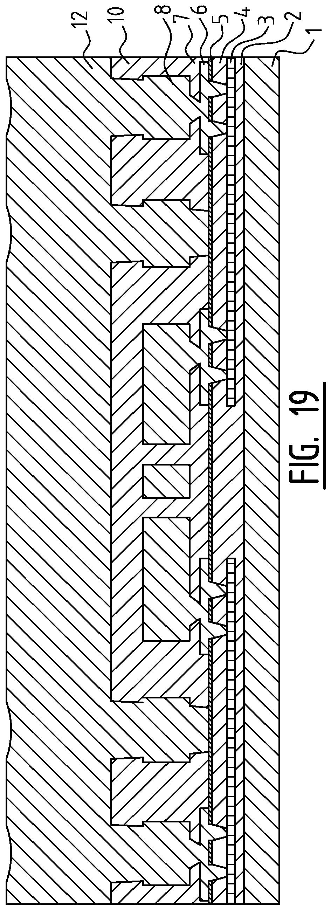

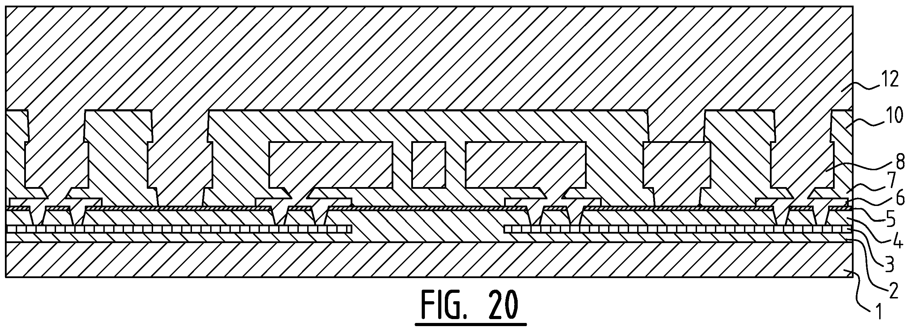

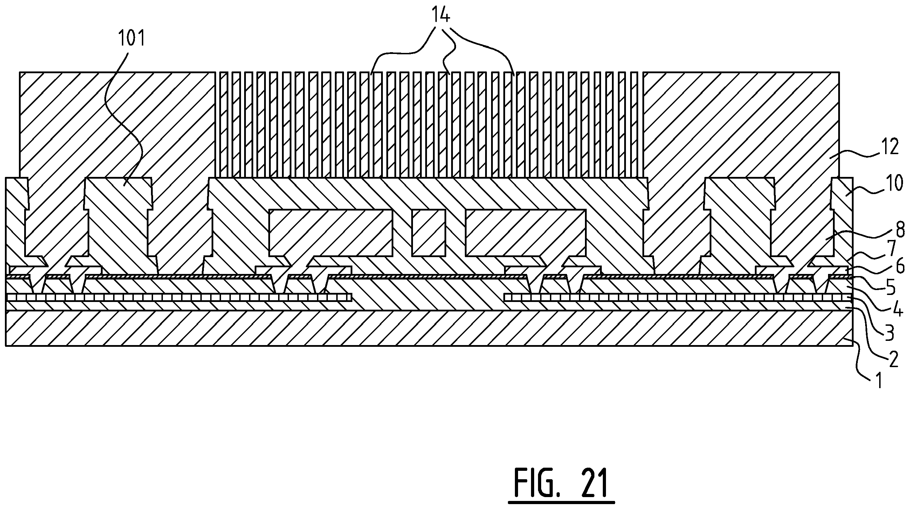

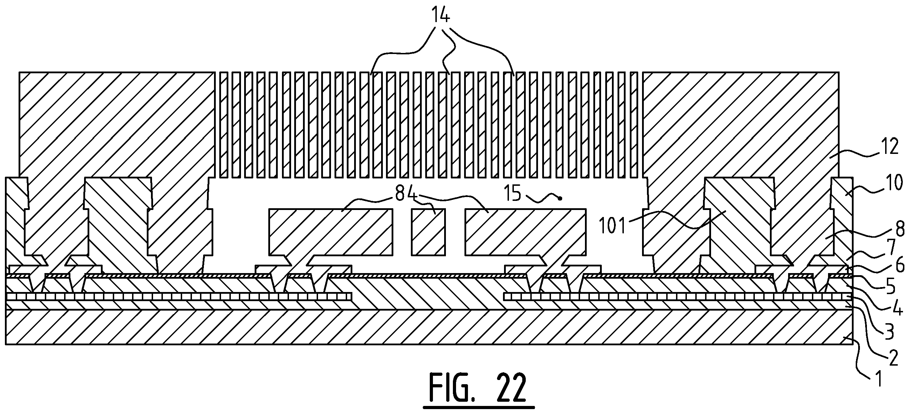

Then the polycrystalline silicon germanium membrane 12 deposition is performed (Fig. 19) (typically having a thickness of 4-10 pm), the front surface of which is optionally planarized by applying a CMP step (Fig. 20), resulting in a substantially flat silicon germanium membrane. Note that the level of the substantially flat upper surface of the remaining portion of sacrificial material 101 corresponds to the level of the lower surface the membrane layer 12. Now the etch hole definition is performed to define the release holes 14 which will be used for removing the sacrificial material 10 under the membrane layer 12 (Fig. 21). Now the release of the membrane layer and of the functional silicon germanium layer within the formed cavity can be performed by using an etching agent, for instance HF in the gas phase, which is passing through the openings or release holes 14 in the membrane layer 12, in order to remove the material of the sacrificial layers 10 (optionally 11), 7, hereby creating cavity or gap 15 below the membrane layer 12(Fig. 22), the cavity comprising the MEMS device. It should be noted that at this time in the process sequence, the portion 101 of the layers of sacrificial material 10 (optionally 11), 7 next or adjacent to the cavity 15 is not removed. This improves the strength of the intermediate and/or final device.

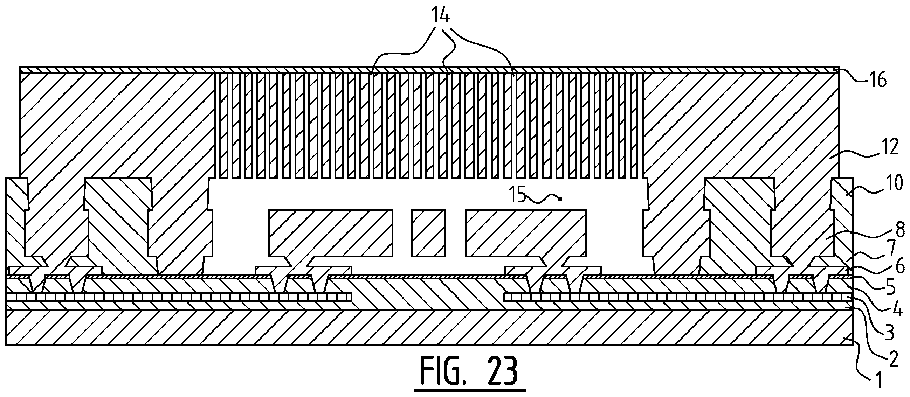

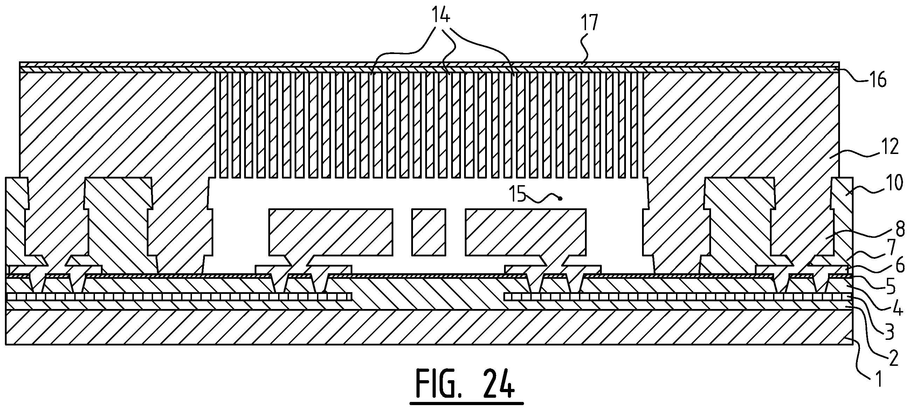

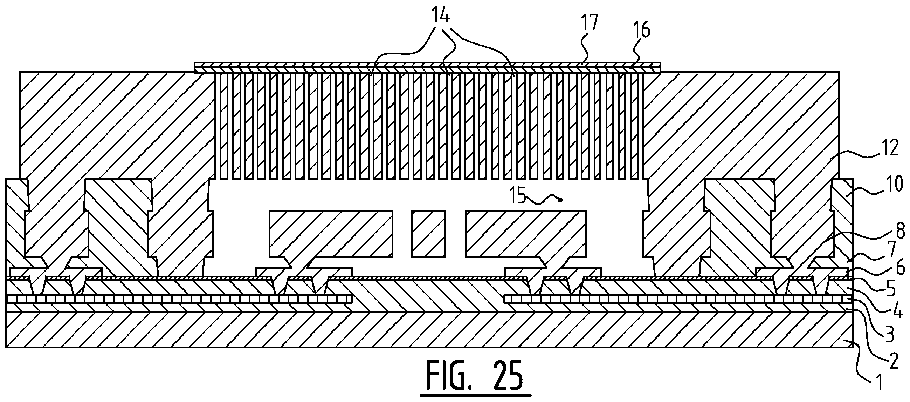

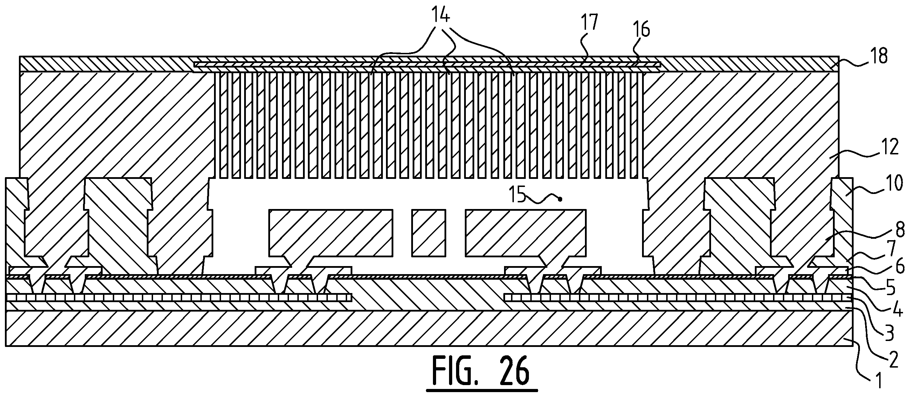

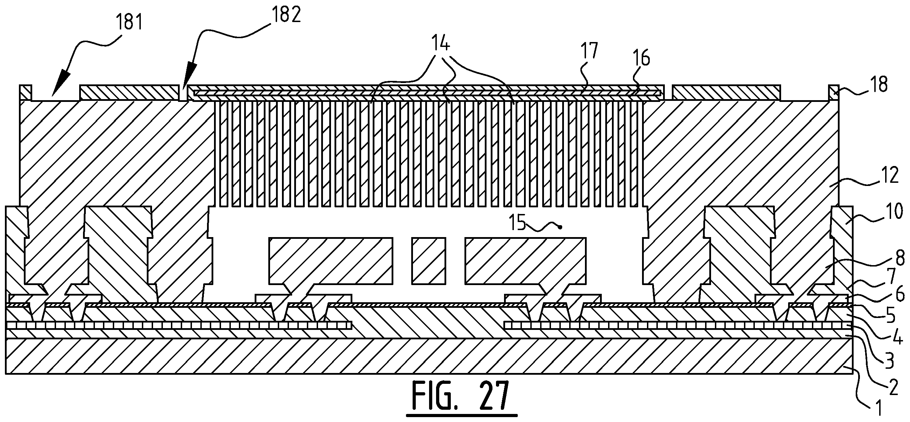

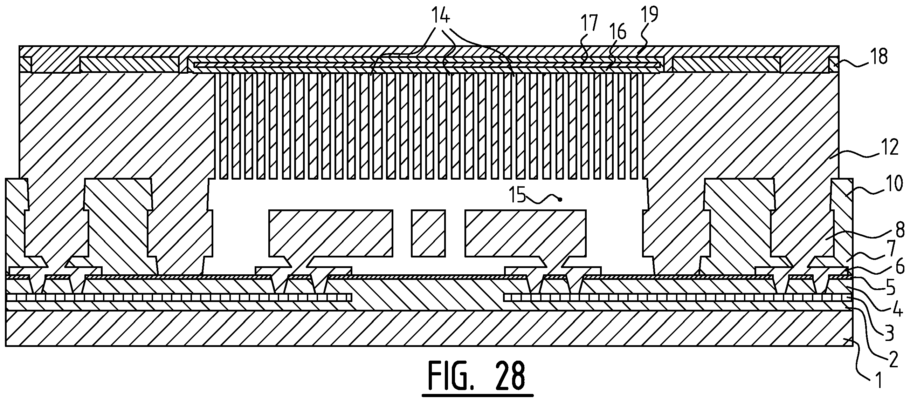

Next the openings or release holes 14 in the membrane layer can be sealed off by state of the art techniques. One of the possible techniques is illustrated below. A sealing layer of silicon oxide 16 is deposited on the front surface of the intermediate device on top of the membrane layer 12 in order to at least partially reduce the width of the openings, or to completely close off the openings (Fig. 23). Later a second sealing layer, for instance an aluminium layer 17, can be deposited (and optionally reflowed) (Fig. 24). The first and second sealing layers, for instance the silicon oxide layer 16 and reflowed aluminium layer 17, hereby provide a sealing layer which is hermetically sealing the openings 14 in the membrane 12 and thus the cavity 15. The sealing layer 16, 17 are further patterned to only remain at the location of the cavity (Fig. 25), whereupon a further silicon oxide layer 18 is deposited (Fig. 26), acting as an electrical isolation layer surrounding the reflowed aluminium layer 17. The silicon oxide layer or isolation layer 18 is now opened at the locations of the bond pads (Fig. 27), whereupon the bond pad layer 19 deposition is performed (Fig. 28). The bond pad layer 19 can also overlay the cavity thereby improving the hermetical sealing of the cavity. As shown in figure 27, an additional opening can be formed in the layer 18 adjacent to the patterned sealing layer 16. When depositing the bond layer 19 also the opening is filled with the bond layer material, thereby also sealing off the sidewall of the sealing layer stack 16,17.

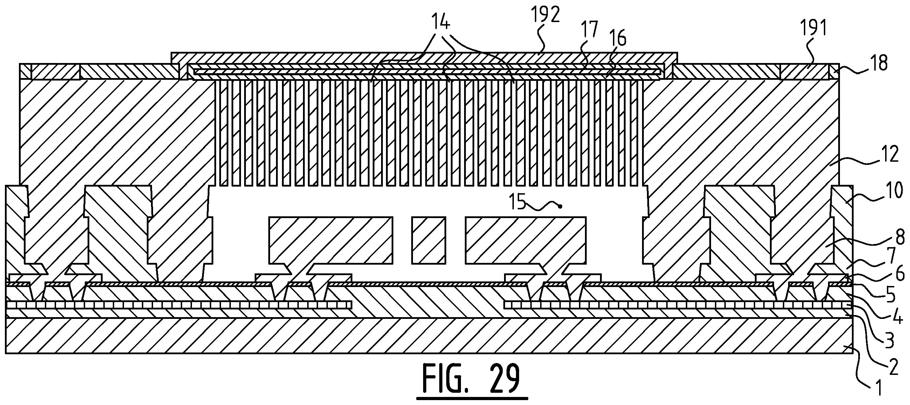

The bond pad layer 19 may comprise aluminium or any material known to be suitable to the skilled person. It may be for instance a 900nm thick Al layer. The bond pad layer 19 (which can optionally be used as an extra sealing layer) is then patterned (Fig. 29) into the bond pads 191 and, optionally, the additional sealing layer 192 on top of the cavity.

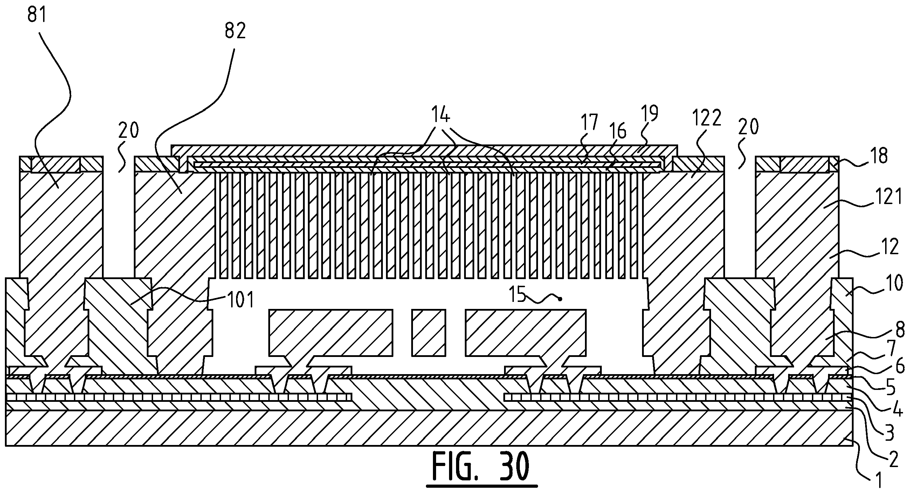

In the preceding process steps the surface of the membrane layer 12 only contained the small etch holes 14 for removing the sacrificial layer 10 when creating the cavity 15. In that way subsequent processing is not hampered by the topography of the membrane layer 12. Only a final silicon germanium patterning step is applied in order to pattern the membrane layer 12 into at least two independent membrane layer blocks 122 and 121 by providing trenches 20 according to predetermined patterns (Fig. 30). In this patterning step the zero-level package of the cavity 15 formed by layer 12 is separated from the pillar on which the bond pad is formed and which is part of the electrical connection between the bond pad and a buried metal layer 3. The independent membrane layer blocks preferably correspond to caps covering the cavity and bond pad areas associated with the electrical connection, which thus comprise portions of the membrane layer.

While some embodiments described herein include some but not other features included in other embodiments, combinations of features of different embodiments are meant to be within the scope of the disclosure, and form different embodiments, as would be understood by the skilled person.

While the principles of the disclosure have been set out above in connection with specific embodiments, it is to be clearly understood that the description is merely made by way of example and not as a limitation of the scope of protection which is determined by the appended claims.

## Claims

1. A method for manufacturing a sealed cavity (15), comprising a MEMS device, comprised in a microelectronic device, comprising
- providing a substrate (1, 2, 3, 4) comprising at least one buried metal layer (3);
- manufacturing at least one MEMS device at the location where said cavity (15) is to be provided;
- forming on said substrate (1, 2, 3, 4) a sacrificial layer (7,10) at least at locations where said cavity (15) is to be provided,
- depositing a membrane layer (12) on top of said sacrificial layer (7,10),
- removing sacrificial material of said sacrificial layer (7,10) through at least one hole in said membrane layer (12), thereafter
- patterning said membrane layer (12) in at least two separate membrane layer blocks (121, 122),
- sealing said cavity by sealing said membrane layer, and
- providing an electrical connection for said MEMS device, said electrical connection comprising said buried metal layer (3) and one of said membrane layer blocks (121, 122),
wherein
- manufacturing said at least one MEMS device comprises forming a structural MEMS layer (8) at least a first portion (84) of which is comprised in said MEMS device and at least a second portion (81) of which is comprised in said electrical connection,
- patterning said membrane layer (12) comprises isolating said electrical connection from a sidewall (82) of said cavity (15), and
- a support structure is formed by a portion (101) of sacrificial material of said sacrificial layer, said support structure providing support for the sidewall of the cavity and for the electrical connection.

2. A method according to claim 1, wherein said portion (101) of sacrificial material is formed with a substantially flat upper surface at a level corresponding with a level of a lower surface of the membrane layer.

3. A method according to claim 1 or 2, wherein isolating the electrical connection from a sidewall of the cavity comprises providing a trench (20) between the electrical connection and the sidewall (82) of the cavity, above the portion (101) of sacrificial material.

4. A method according to any of the previous claims, wherein patterning said membrane layer (12) comprises forming a cap membrane layer block (122) positioned substantially above said cavity (15).

5. A method according to any of the previous claims, wherein patterning said membrane layer (12) comprises forming a bond pad membrane layer block (121) positioned adjacent to said cavity (15).

6. A method according to any of the previous claims, further comprising forming at least one hole (14) in said membrane (12) at a location substantially above said cavity (15), for removing at least part of said sacrificial layer (7,10).

7. A microelectronic device comprising a cavity (15) formed on a substrate (1, 2, 3, 4) comprising at least one buried metal layer (3), the cavity comprising at least one MEMS device formed in a first portion (84) of a structural MEMS layer (8),
- a membrane layer (12) above said cavity (15) comprising at least one etch hole (14), said membrane layer (12) being adapted for allowing the removal of a sacrificial material (7,10) within said cavity (15) through said membrane layer (12), wherein said membrane layer (12) is a single piece layer,
- packaging anchors (82) defining sidewalls of said cavity (15), and
- an electrical connection for said MEMS device, said electrical connection comprising said buried metal layer (3) and a second portion (81) of said MEMS structural layer (8), wherein the microelectronic device further comprises
- at least a support structure (101) of sacrificial material at locations outside said cavity (15),
- said support structure (101) being formed by a portion (101) of sacrificial material also used for temporarily filling said cavity (15) with sacrificial material, and
- said support structure (101) surrounding and joining said packaging anchors (82) and said electrical connection (81).

8. A microelectronic device according to claim 7, further comprising at least one etch hole (14) in said membrane layer communicating with said cavity (15).

9. A microelectronic device according to claim 8, wherein said support structure (101) comprises a substantially flat upper surface at a level which corresponds with the level of the lower surface of said membrane layer.

## Patentansprüche

1. Verfahren zur Herstellung eines abgedichteten Hohlraums (15), der eine MEMS-Vorrichtung aufweist, die in einer mikroelektronischen Vorrichtung enthalten ist, das aufweist:
- Bereitstellen eines Substrats (1, 2, 3, 4), das wenigstens eine vergrabene Metallschicht (3) aufweist;
- Herstellen wenigstens einer MEMS-Vorrichtung an der Stelle, wo der Hohlraum (15) bereitgestellt werden soll;
- Ausbilden einer Opferschicht (7, 10) auf dem Substrat (1, 2, 3, 4) wenigstens an Stellen, wo der Hohlraum (15) bereitgestellt werden soll,
- Abscheiden einer Membranschicht (12) auf der Opferschicht (7, 10),
- Entfernen des Opfermaterials der Opferschicht (7, 10) durch wenigstens ein Loch in der Membranschicht (12), danach
- Strukturieren der Membranschicht (12) in wenigstens zwei getrennten Membranschichtblöcken (121, 122),
- Abdichten des Hohlraums durch Abdichten der Membranschicht, und
- Bereitstellen einer elektrischen Verbindung für die MEMS-Vorrichtung, wobei die elektrische Verbindung die vergrabene Metallschicht (3) und einen der genannten Membranschichtblöcke (121, 122) aufweist,
wobei
- das Herstellen der wenigstens einen MEMS-Vorrichtung das Ausbilden einer MEMS-Strukturschicht (8) wenigstens an einem ersten Abschnitt (84), der in der MEMS-Vorrichtung enthalten ist, und wenigstens einem zweiten Abschnitt (81), der in der elektrischen Verbindung enthalten ist, aufweist,
- das Strukturieren der Membranschicht (12) das Isolieren der elektrischen Verbindung gegen eine Seitenwand (82) des Hohlraums (15) aufweist, und
- eine Haltestruktur durch einen Abschnitt (101) des Opfermaterials der Opferschicht ausgebildet wird, wobei die Haltestruktur Halt für die Seitenwand des Hohlraums und für die elektrische Verbindung bereitstellt.

2. Verfahren nach Anspruch 1, wobei der Abschnitt (101) aus Opfermaterial mit einer im Wesentlichen flachen oberen Oberfläche auf einer Höhe ausgebildet ist, die einer Höhe einer unteren Oberfläche der Membranschicht entspricht.

3. Verfahren nach Anspruch 1 oder 2, wobei das Isolieren der elektrischen Verbindung gegen eine Seitenwand des Hohlraums, das Bereitstellen eines Grabens (20) zwischen der elektrischen Verbindung und der Seitenwand (82) des Hohlraums über dem Abschnitt (101) aus Opfermaterial aufweist.

4. Verfahren nach einem der vorhergehenden Ansprüche, wobei das Strukturieren der Membranschicht (12) das Ausbilden eines Verschlussmembranschichtblocks (122) aufweist, der im Wesentlichen über dem Hohlraum (15) positioniert ist.

5. Verfahren nach einem der vorhergehenden Ansprüche, wobei das Strukturieren der Membranschicht (12) das Ausbilden eines Kontaktflächen-Membranschichtblocks (121) aufweist, der benachbart zu dem Hohlraum (15) positioniert ist.

6. Verfahren nach einem der vorhergehenden Ansprüche, das ferner das Ausbilden wenigstens eines Lochs (14) in der Membran (12) an einer Stelle im Wesentlichen oberhalb des Hohlraums (15) aufweist, um wenigstens einen Teil der Opferschicht (7, 10) zu entfernen.

7. Mikroelektronische Vorrichtung, aufweisend einen Hohlraum (15), der auf einem Substrat (1, 2, 3, 4) ausgebildet ist, das wenigstens eine vergrabene Metallschicht (3) aufweist, wobei der Hohlraum wenigstens eine MEMS-Vorrichtung aufweist, die in einem ersten Abschnitt (84) einer MEMS-Strukturschicht (8) ausgebildet ist,
- eine Membranschicht (12) über dem Hohlraum (15), die wenigstens ein Ätzloch (14) aufweist, wobei die Membranschicht (12) geeignet ist, die Entfernung eines Opfermaterials (7, 10) innerhalb des Hohlraums (15) durch die Membranschicht (12) zuzulassen, wobei die Membranschicht (12) eine einteilige Schicht ist,
- Gehäuseanker (84), die Seitenwände des Hohlraums (15) definieren, und
- eine elektrische Verbindung für die MEMS-Vorrichtung, wobei die elektrische Verbindung die vergrabene Metallschicht (3) und einen zweiten Abschnitt (81) der MEMS-Strukturschicht (8) aufweist, wobei die mikroelektronische Vorrichtung ferner aufweist:
- wenigstens eine Haltestruktur (101) für Opfermaterial an Stellen außerhalb des Hohlraums (15),
- wobei die Haltestruktur (101) durch einen Abschnitt (101) aus Opfermaterial ausgebildet ist, das auch dazu verwendet wird, den Hohlraum (15) vorübergehend mit Opfermaterial zu füllen, und
- wobei die Haltestruktur (101) die Gehäuseanker (82) und die elektrische Verbindung (81) umgibt und verbindet.

8. Mikroelektronische Vorrichtung nach Anspruch 7, die ferner wenigstens ein Ätzloch (14) in der Membranschicht aufweist, das mit dem Hohlraum (15) in Verbindung steht.

9. Mikroelektronische Vorrichtung nach Anspruch 8, wobei die Haltestruktur (101) eine im Wesentlichen flache obere Oberfläche auf einer Höhe aufweist, die der Höhe der unteren Oberfläche der Membranschicht entspricht.

## Revendications

1. Procédé pour fabriquer une cavité étanche (15), comprenant un dispositif MEMS, compris dans un dispositif microélectronique, comprenant
- la fourniture d'un substrat (1, 2, 3, 4) comprenant au moins une couche métallique enterrée (3) ;
- la fabrication d'au moins un dispositif MEMS à l'endroit où ladite cavité (15) doit être fournie ;
- la formation sur ledit substrat (1, 2, 3, 4) d'une couche sacrificielle (7, 10) au moins aux endroits où ladite cavité (15) doit être fournie,
- le dépôt d'une couche membrane (12) sur ladite couche sacrificielle (7, 10),
- le retrait de matériau sacrificiel de ladite couche sacrificielle (7, 10) par au moins un trou dans ladite couche membrane (12),
ensuite
- la structuration de ladite couche membrane (12) dans au moins deux blocs de couche membrane séparés (121, 122),
- l'étanchéité de ladite cavité en rendant étanche ladite couche membrane, et
- la fourniture d'une connexion électrique pour ledit dispositif MEMS, ladite connexion électrique comprenant ladite couche métallique enterrée (3) et l'un desdits blocs de couche membrane (121, 122),
dans lequel
- la fabrication dudit au moins un dispositif MEMS comprend la formation d'une couche MEMS structurale (8) dont au moins une première portion (84) est comprise dans ledit dispositif MEMS et dont au moins une deuxième portion (81) est comprise dans ladite connexion électrique,
- la structuration de ladite couche membrane (12) comprend l'isolation de ladite connexion électrique d'une paroi latérale (82) de ladite cavité (15), et
- une structure de support est formée par une portion (101) de matériau sacrificiel de ladite couche sacrificielle, ladite structure de support fournissant un support pour la paroi latérale de la cavité et pour la connexion électrique.

2. Procédé selon la revendication 1, dans lequel ladite portion (101) de matériau sacrificiel est formée d'une surface supérieure sensiblement plate à un niveau correspondant à un niveau d'une surface inférieure de la couche membrane.

3. Procédé selon la revendication 1 ou 2, dans lequel l'isolation de la connexion électrique d'une paroi latérale de la cavité comprend la fourniture d'une tranchée (20) entre la connexion électrique et la paroi latérale (82) de la cavité, au-dessus de la portion (101) de matériau sacrificiel.

4. Procédé selon l'une quelconque des revendications précédentes, dans lequel la structuration de ladite couche membrane (12) comprend la formation d'un bloc de couche membrane chapeau (122) positionné sensiblement au-dessus de ladite cavité (15).

5. Procédé selon l'une quelconque des revendications précédentes, dans lequel la structuration de ladite couche membrane (12) comprend la formation d'un bloc de couche membrane plot de liaison (121) positionné de manière adjacente à ladite cavité (15).

6. Procédé selon l'une quelconque des revendications précédentes, comprenant en outre la formation d'au moins un trou (14) dans ladite membrane (12) à un endroit sensiblement au-dessus de ladite cavité (15), pour retirer au moins une partie de ladite couche sacrificielle (7, 10).

7. Dispositif microélectronique comprenant une cavité (15) formée sur un substrat (1, 2, 3, 4) comprenant au moins une couche métallique enterrée (3), la cavité comprenant au moins un dispositif MEMS formé dans une première portion (84) d'une couche MEMS structurale (8),
- une couche membrane (12) au-dessus de ladite cavité (15) comprenant au moins un trou de gravure (14), ladite couche membrane (12) étant adaptée pour permettre le retrait d'un matériau sacrificiel (7, 10) dans ladite cavité (15) par le biais de ladite couche membrane (12), dans lequel ladite couche membrane (12) est une couche monobloc,
- des ancrages de mise sous boîtier (82) définissant des parois latérales de ladite cavité (15), et
- une connexion électrique pour ledit dispositif MEMS, ladite connexion électrique comprenant ladite couche métallique enterrée (3) et une deuxième portion (81) de ladite couche structurale MEMS (8),
dans lequel le dispositif microélectronique comprend en outre
- au moins une structure de support (101) de matériau sacrificiel à des endroits à l'extérieur de ladite cavité (15),
- ladite structure de support (101) étant formée par une portion (101) de matériau sacrificiel également utilisée pour remplir provisoirement ladite cavité (15) avec du matériau sacrificiel, et
- ladite structure de support (101) entourant et reliant lesdits ancrages de mise sous boîtier (82) et ladite connexion électrique (81).

8. Dispositif microélectronique selon la revendication 7, comprenant en outre au moins un trou de gravure (14) dans ladite couche membrane communiquant avec ladite cavité (15).

9. Dispositif microélectronique selon la revendication 8, dans lequel ladite structure de support (101) comprend une surface supérieure sensiblement plate à un niveau qui correspond au niveau de la surface inférieure de ladite couche membrane.
